# EUROPÄISCHE PATENTANMELDUNG

(11) **EP 1 182 701 A1**
(43) Veröffentlichungstag der Anmeldung: **27.02.2002**
(21) Anmeldenummer: 00810742.7
(22) Anmeldetag: 21.08.2000
(51) Int. Cl.: H01L 23/051, H01L 23/367, H01L 23/492, H01L 21/48

(54) **Verfahren zur Herstellung eines Pufferelementes zur Verminderung von mechanischen Spannungen**

(71) Anmelder: ABB RESEARCH LTD., 8050 Zürich (CH)
(72) Erfinder: Knapp, Wolfgang, 5430 Wettingen (CH); Zwick, Fabian, 8134 Adliswil (CH)
(74) Vertreter: ABB Patent Attorneys

(57) **Zusammenfassung**

In einem Verfahren zur Herstellung eines selbsttragenden Pufferelementes, welches mechanische Spannungen zwischen zwei Materialien mit unterschiedlichen thermischen Ausdehnungskoeffizienten vermindern soll und deshalb im wesentlichen unabhängig voneinander expansions- und/oder kontraktionsfähige Bereiche aufweist, wird ein Blech (1) so zu einer dreidimensionalen Struktur (1',1") verformt, dass diese in Gebiete unterteilbar ist, welche im wesentlichen unabhängig voneinander expansions- und/oder kontraktionsfähig sind, worauf die dreidimensionale Struktur (1',1") verpresst wird und zu einer strukturierten Platte (P) verarbeitet wird.

Es lassen sich somit einfach herstellbare, stabile und einfach handhabbare Pufferelemente schaffen, welche insbesondere in der Halbleitertechnik ihre Anwendung finden.

## Beschreibung

### Technisches Gebiet

Die Erfindung bezieht sich auf das Gebiet der Leistungselektronik. Sie betrifft ein Verfahren zur Herstellung eines Pufferelementes zur Verminderung von mechanischen Spannungen zwischen zwei Materialien mit unterschiedlichen thermischen Ausdehnungskoeffizienten gemäss dem Oberbegriff des Patentanspruches 1 sowie ein Pufferelement gemäss Oberbegriff des Patentanspruches 14.

### Stand der Technik

Derartige Pufferelemente werden in Hochleistungs-Halbleiterbauelementen eingesetzt, um thermisch induzierte mechanische Spannungen zwischen einem Halbleiterelement und einer plattenförmigen Metallelektrode zu minimieren. Mechanische Spannungen führen zu einer Ermüdung der Verbindungsschichten zwischen dem Halbleiterelement und den Metallelektroden, beeinträchtigen somit das elektrische Verhalten des Halbleiterbauelementes und können zu dessen Ausfall führen.

Im Stand der Technik werden deshalb einerseits sogenannte Presspackmodule verwendet, in welchen Halbleiterchip und Metallelektroden mittels externen Federelementen ohne Verwendung von Lotschichten aneinander gepresst werden. Dadurch lassen sich zwar gleitende elektrische Kontakte schaffen, welche keinen wärmebedingten mechanischen Spannungen ausgesetzt sind. Nachteilig ist jedoch, dass diese Kontakte einen relativ hohen thermischen Widerstand aufweisen, so dass die Funktionsfähigkeit des Bauelementes limitiert ist.

Ferner ist es bekannt, Pufferelemente zwischen Halbleiterchip und Metallelektroden anzuordnen, um die mechanischen Spannungen aufzunehmen. Die Pufferelemente müssen, damit die Funktionsfähigkeit des Halbleiterbauelementes nicht beeinträchtig wird, eine gute thermische und elektrische Leitfähigkeit aufweisen.

In James Burgess et al., "Solder Fatigue Problems in a Power Package", IEEE Transactions on components, hybrids and manufacturing technology, vol. chmt-7, no. 4, December 1984, Seite 405-410, wird ein derartiges Pufferelement, hier "Structured Copper" genannt, beschrieben. Dieses Pufferelement aus Kupfer besteht aus einer Vielzahl aneinandergereihter Kupferdraht-Stückchen, welche sich unabhängig voneinander bewegen können. Werden sie als Bindeglied zwischen zwei Materialien mit unterschiedlichen Wärmeausdehnungskoeffizienten eingesetzt, so ermöglicht ihre freie Bewegungsfähigkeit, dass sie mechanische Spannungen aufnehmen, ohne diese an die Verbindungspartner zu übertragen.

In Homer H. et al, "Structured copper: a pliable high conductance material for bonding to silicon power devices", IEEE Transactions on components, hybrids and manufacturing technology, vol. chmt-6, no. 4, December 1983, Seite 460-466, wird beschrieben, wie derartige "Structured Copper"-Elemente hergestellt werden. Ein dünner, beschichteter Kupferfaden, typischerweise mit einem Durchmesser von einem Viertel Millimeter, wird um zwei beabstandet angeordnete Stäbe gewickelt. Die so entstandene Spule wird in ein Kupferrohr eingeschoben, welches durch eine Drahtziehbank gezogen wird. Anschliessend wird das Rohr gemeinsam mit der Spule mehrere Male gepresst, bis eine Wicklungsdichte von bis zu 1600 Drähte pro Quadratzentimeter erreicht wird. Zum Schluss wird das Rohr in Scheiben geschnitten. Es wird eine Scheibe erhalten, bestehend aus losen Kupferdrahtstückchen, welche von einem Kupferring zusammengehalten werden. Soll der Ring entfernt werden, müssen die Kupferdrahtstückchen an einem Ende miteinander verbunden, beispielsweise zusammengelötet werden.

Ein derartiges "Structured Copper"-Element ist auch in US-A-4'385'310 beschrieben.

Diese Pufferelemente aus strukturiertem Kupfer haben sich zwar bewährt. Leider ist jedoch ihre Herstellung zeitaufwendig und deshalb kostenintensiv. Zudem sind diese Pufferelemente aufgrund der losen Drahtstückchen brüchig und schwierig zu handhaben.

### Darstellung der Erfindung

Es ist deshalb Aufgabe der Erfindung, ein einfacheres Verfahren zur Herstellung eines Pufferelementes sowie ein stabileres Pufferelement zu schaffen.

Diese Aufgabe löst ein Herstellungsverfahren mit den Merkmalen des Patentanspruches 1 und ein Pufferelement mit den Merkmalen des Patentanspruches 14.

Erfindungsgemäss wird von einem Blech ausgegangen, wobei das Blech durch dreidimensionale Verformung in Gebiete unterteilt wird, welche im wesentlichen unabhängig voneinander expansions- und/oder kontraktionsfähig sind, und durch anschliessende Pressung zu einem Pufferelement in Form einer strukturierten Platte übergeführt wird, welche somit im wesentlichen unabhängig voneinander expansions- und/oder kontraktionsfähige Bereiche aufweist.

Die Herstellung ist durch die Wahl eines Blechs anstelle von Kupferdrähten massiv vereinfacht. Drei bis vier einfache Bearbeitungsschritte reichen zur Herstellung der strukturierten Platte aus.

Das erfindungsgemässe Pufferelement ist mindestens annähernd einstückig ausgebildet und muss deshalb nicht durch externe Fixierungsmittel zusammengehalten werden. Es ist selbsttragend, wesentlich stabiler und einfacher zu handhaben als die bekannten "Structured Copper"-Elemente. Ein weiterer Vorteil ist, dass sich Pufferelemente mit weitaus geringeren Dicken fertigen lassen als die bekannten aus Drahtstückchen zusammengesetzten "Structured Copper"-Elemente.

In einer bevorzugten ersten Variante des Verfahrens wird das Blech durch Tiefziehen strukturiert, um dann durch lateral und vorzugsweise auch vertikale Verpressung in eine mindestens annähernd planparallel strukturierte Platte verformt zu werden.

In einer bevorzugten zweiten Variante des Verfahrens wird das Blech gefaltet und im gefalteten Zustand zu einer Rolle aufgewickelt, welche anschliessend in senkrechter Richtung zu ihrer Längsachse zusammengepresst wird. Diese Rolle lässt sich entlang ihrer Längsachse in Scheiben schneiden, welche wiederum, vorzugsweise nach einer vertikalen Verpressung, die gewünschten plattenförmigen Pufferelemente bilden.

Weitere vorteilhafte Varianten des Verfahrens und vorteilhafte Ausführungsformen gehen aus den abhängigen Patentansprüchen hervor.

### Kurze Beschreibung der Zeichnungen

Im folgenden wird der Erfindungsgegenstand anhand von bevorzugten Ausführungsbeispielen, welche in den beiliegenden Zeichnungen dargestellt sind, näher erläutert. Es zeigen:
- Figur 1a bis 1f: eine Herstellung eines Pufferelementes in einer ersten Variante des erfindungsgemässen Verfahrens in mehreren Schritten und
- Figur 2a bis 2f: die Herstellung des Pufferelementes gemäss einer zweiten Variante des erfindungsgemässen Verfahrens.

### Wege zur Ausführung der Erfindung

Im erfindungsgemässen Verfahren wird von einem Blech 1 ausgegangen. Vorzugsweise handelt es sich dabei um Kupfer- oder Aluminiumblech. Das Blech weist vorzugsweise eine Dicke von 0.1 mm bis 2 mm auf. Es sollte genügend weich sein, um sich auf einfache Art und Weise verformen zu lassen, ohne dabei zu brechen. Die Verwendung eines rechteckförmigen, insbesondere quadratischem Blechs ist bevorzugt.

Erfindungsgemäss wird in einem ersten Herstellungsschritt das Blech 1 zu einer dreidimensionalen Struktur 1',1" verformt, welche in Gebiete unterteilbar ist, die im wesentlichen unabhängig voneinander expansions- und/oder kontraktionsfähig sind.

In einem zweiten Schritt wird diese dreidimensionale Struktur 1',1" verpresst, um dann in einem nachfolgenden Schritt zu einer strukturierten Platte P mit vorgegebener Dicke verarbeitet zu werden.
Das Pufferelement weist somit die Form einer strukturierten Platte auf, welche aus einem zusammengepressten, eine mäanderartige Form aufweisendes Blecht besteht.

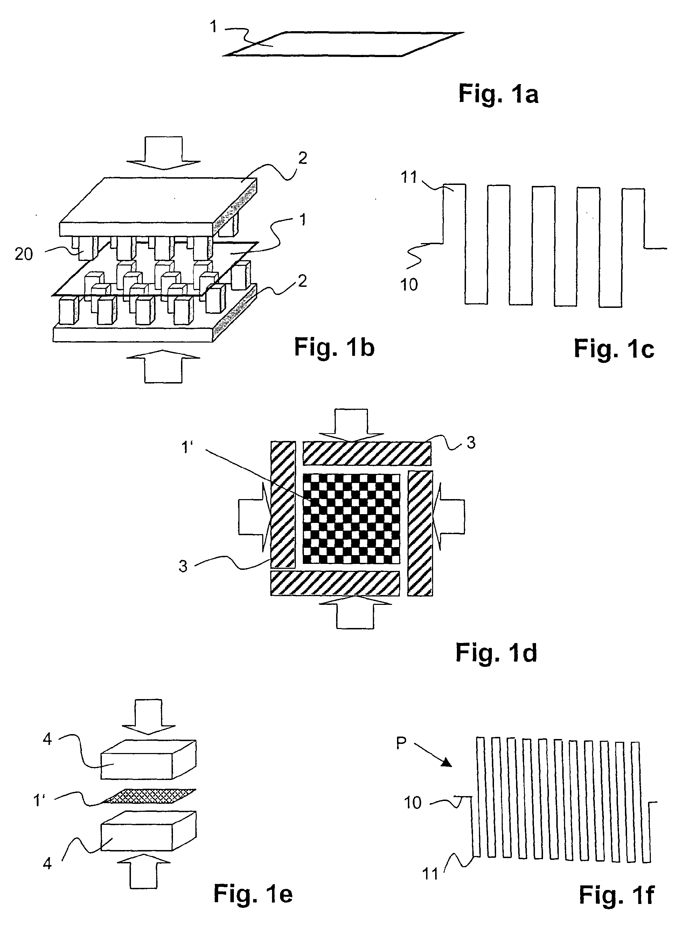

In den Figuren 1a bis 1f ist eine erste Variante des erfindungsgemässen Herstellungsverfahrens dargestellt. In Figur 1a ist das oben beschriebene Blech 1 dargestellt. In einem ersten Herstellungsschritt gemäss Figur 1b wird das Blech 1 tiefgezogen, indem aus einer Blechebene 10 herausragende Finger 11 eingepresst werden. Dies erfolgt beispielsweise mittels eines Stempels 2, welcher entsprechend geformte Stempelbacken 20 aufweist. Vorzugsweise werden dabei beidseitig der Blechebene 10 Finger 11 eingepresst, beispielsweise indem zeitgleich von beiden Seiten Stempel 2 aneinandergepresst werden.

Es entsteht, wie in Figur 1c dargestellt, eine dreidimensionale Struktur 1', welche einen mäanderartigen Querschnitt aufweist. In Figur 1c sind rechteckförmige Finger 11 dargestellt. Die Form hängt jedoch von der Art der verwendeten Stempel 2 ab, welche entsprechend den zu erzielenden Eigenschaften des Pufferelementes gewählt werden. Insbesondere können die Finger 11 auch gerundete Oberflächen aufweisen. Die Struktur 1' weist in diesem Beispiel in der Aufsicht ein karoähnliches-Muster auf, wie dies am besten in Figur 1d ersichtlich ist. Die schwarzen Flächen verdeutlichen hier nach unten ragende Finger 11, die weissen Flächen nach oben ragende Finger 11. Andere Formen sind jedoch möglich.

In einem nächsten Herstellungsschritt, welcher in Figur 1d dargestellt ist, wird die dreidimensionale Struktur 1' parallel zur Blechebene 10 lateral verpresst. Dabei wird die Struktur in der Blechebene von mindestens zwei, hier von vier Seiten mit ersten Pressbacken 3 beaufschlagt. Vorzugsweise erfolgt diese Pressung gleichförmig von allen vier Seiten. Dabei ist zu beachten, dass die Struktur 1'nicht zu stark in senkrechter Richtung zur Blechebene 10 ausweichen kann. Vorzugsweise wird dies durch Einlegen der Struktur 1' zwischen zwei hier nicht dargestellte Gegenplatten verhindert. Die Struktur 1' wird zu einer je nach späterer Verwendung gewünschten Dichte zusammengepresst. Vorzugsweise weist sie nach der Pressung eine Dichte von 70 bis 99% auf.

In einem letzten Schritt gemäss Figur 1d wird die dreidimensionale Struktur 1' in senkrechter Richtung zur Blechebene 10 vertikal zusammengepresst. Dies erfolgt durch beidseitige Beaufschlagung mit zweiten Pressbacken 4.

Dieser letzte Verfahrensschritt lässt sich zeitgleich der lateralen Verpressung durchführen. Zudem lassen sich als Gegenplatten die dritten Stempel 4 einsetzen.

In Figur 1f ist das erhaltene Pufferelement im Querschnitt dargestellt. Es besteht aus einer Platte P, welche einen mäanderartigen Querschnitt aufweist, wobei der Mäander zu einer dichten Packung zusammengepresst ist, jedoch trotzdem den Schenkeln des Mäanders eine voneinander weitgehend unabhängige Bewegung erlaubt.

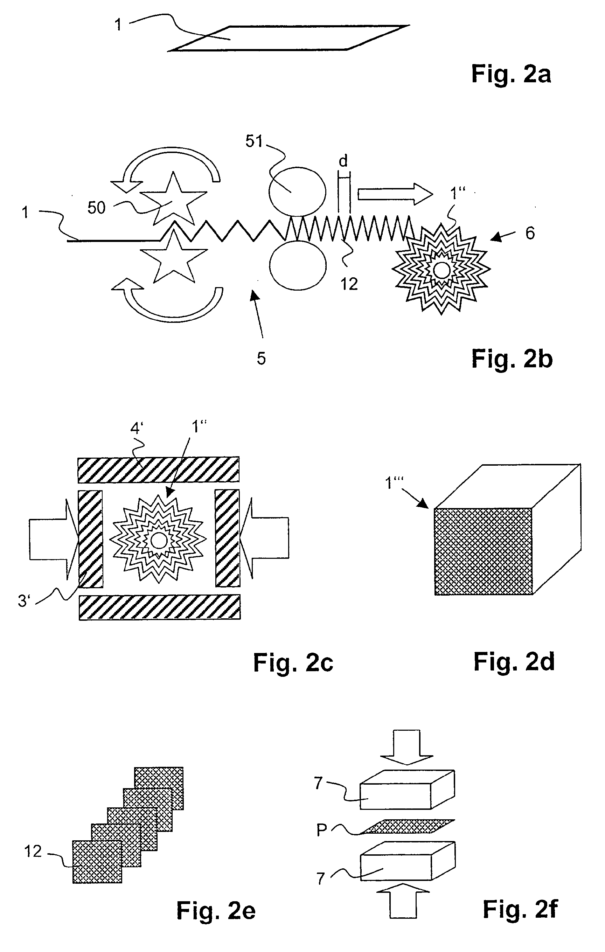

In den Figuren 2a bis 2f ist eine zweite Variante des erfindungsgemässen Verfahrens dargestellt. Ausgangsmaterial gemäss Figur 2a ist auch hier das Blech 1. Dieses wird in einem ersten Verfahrensschritt durch einen Falzapparat 5 geleitet, wobei in Figur 2b lediglich zwei sternförmige Falzwalzen 50 und zwei Förderwalzen 51 schematisch dargestellt sind. Das Blech 1 wird zwischen den zwei Falzwalzen 50 gefaltet. Im hier dargestellten Beispiel wird das Blech 1 in regelmässigen Abständen geknickt, so dass ein Wellblech 12 mit spitzen Kanten entsteht. Andere Falt-Formen sind jedoch auch möglich, insbesondere runde Kanten. In den anschliessend angeordneten Förderwalzen 51 wird das Wellblech 12 mit einem gewünschten Zackenabstand d zu einer Wickelvorrichtung 6 gebracht. Auf dieser Wickelvorrichtung 6 wird das gefaltete Ausgangsmaterial zu einer strukturierten Rolle 1" mit einem sternförmigen Querschnitt aufgewickelt. Dabei wird darauf geachtet, dass die gefaltete Struktur des Blechs 1 erhalten bleibt. Das heisst, die Wickelgeschwindigkeit und die Spannung der Zuführung müssen entsprechend gewählt werden.

Die so entstandene dreidimensionale Struktur in Form der Rolle 1" wird in einem nächsten Verfahrensschritt gemäss Figur 2c in mindestens annähernd senkrechter Richtung zu ihrer Längsachse zusammengepresst. Vorzugsweise wird die strukturierte Rolle 1" in eine rechteckförmige, insbesondere quadratische Querschnittsform gepresst. Hierfür werden wiederum Pressbacken 3' verwendet. Vorzugweise wird die Rolle 1" von mindestens zwei gegenüberliegenden Seiten her gleichzeitig mit den Pressbacken 3' beaufschlagt, wobei an den übrigen Seiten Gegenplatten 4' vorhanden sind.

In Figur 2d ist die zusammengepresste, nunmehr kubusförmige Rolle 1''' dargestellt. Sie weist eine Dichte auf, welche dem vorgesehenen Verwendungszweck angepasst ist. Bei der Verwendung als Zwischenlage zwischen einen Halbleiterchip und einer Metallplatte in einem Hochleistungshalbleiterelement beträgt die Dichte vorzugsweise 70 bis 99%.
In einem nächsten Verfahrensschritt gemäss Figur 2e wird die zusammengepresste Rolle 1''' entlang ihrer Längsachse in Scheiben 12 geschnitten.

Vorzugsweise werden die Scheiben 12 in einem letzten Verfahrensschritt senkrecht zu ihrer Scheibenebene mittels Pressbacken 7 zusammengepresst, um eine möglichst plane Oberfläche zu erhalten. Diese Pressung lässt sich bei jeder Scheibe einzeln oder für mehrere Scheiben gemeinsam durchführen, wobei im letzeren Fall vorzugsweise Zwischenlagen verwendet werden. Es resultiert wiederum ein Pufferelement in Form einer strukturierten Platte P, welche aus einem einstückigen, spiralförmig gewickelten Blech besteht, wobei die Spirale Windungen aufweist, welche mäanderförmig verlaufen.

Das erfindungsgemässe Pufferelement eignet sich allgemein als Verbindungselement von zwei Materialien mit unterschiedlichen thermischen Ausdehnungskoeffizienten. Ein bevorzugter Anwendungsbereich liegt jedoch in der Halbleitertechnik.

### Bezugszeichenliste

- 1: Blech
- 1': Dreidimensionale Struktur
- 1": strukturierte Rolle
- 1''': zusammengepresste Rolle
- 10: Blechebene
- 11: Finger
- 12: Wellblech
- 2: Stempel
- 20: Stempelbacken
- 3: erste Pressbacken
- 3': Pressbacken
- 4: zweite Pressbacken
- 4': Gegenplatten
- 5: Falzapparat
- 50: Falzwalzen
- 51: Förderwalzen
- 6: Wickelvorrichtung
- 7: Dritte Pressbacken
- d: Zackenabstand
- P: strukturierte Platte

## Patentansprüche

1. Verfahren zur Herstellung eines selbsttragenden Pufferelementes zur Verminderung von mechanischen Spannungen zwischen zwei Materialien mit unterschiedlichen thermischen Ausdehnungskoeffizienten, wobei das Pufferelement im wesentlichen unabhängig voneinander expansions- und/oder kontraktionsfähige Bereiche aufweist,
**dadurch gekennzeichnet, dass**
ein Blech (1) so zu einer dreidimensionalen Struktur (1',1") verformt wird, dass die dreidimensionale Struktur (1',1") in Gebiete unterteilbar ist, welche im wesentlichen unabhängig voneinander expansions- und/oder kontraktionsfähig sind, und
dass die dreidimensionale Struktur (1',1") verpresst wird und zu einer strukturierten Platte (P) verarbeitet wird.

2. Verfahren nach Anspruch 1, **dadurch gekennzeichnet, dass** ein Blech (1) aus Kupfer oder Aluminium verwendet wird.

3. Verfahren nach Anspruch 1, **dadurch gekennzeichnet, dass** ein Blech (1) mit einer Dicke von 0.1 mm bis 2 mm verwendet wird.

4. Verfahren nach Anspruch 1, **dadurch gekennzeichnet, dass** zur Bildung der dreidimensionalen Struktur (1") das Blech (1) tiefgezogen wird, wobei aus einer Blechebene (10) herausragende Finger (10) eingepresst werden, und dass die dreidimensionale Struktur (1") parallel zur Blechebene (10) und senkrecht zu ihr zusammengepresst wird.

5. Verfahren nach Anspruch 4, **dadurch gekennzeichnet, dass** die Finger (11) beidseitig des Blechs (1) eingepresst werden.

6. Verfahren nach Anspruch 4, **dadurch gekennzeichnet, dass** die dreidimensionale Struktur (1') in der Blechebene (10) in mindestens zwei, insbesondere in vier Richtungen verpresst wird.

7. Verfahren nach Anspruch 4, **dadurch gekennzeichnet, dass** die dreidimensionale Struktur (1') parallel zur Blechebene (10) bis zu einer Dichte von 70 bis 99% zusammengepresst wird.

8. Verfahren nach Anspruch 4, **dadurch gekennzeichnet, dass** die dreidimensionale Struktur (1') senkrecht zur Blechebene (10) bis zu einem Mass von 0 bis 30% zusammengestaucht wird

9. Verfahren nach Anspruch 1, **dadurch gekennzeichnet, dass** zur Bildung der dreidimensionalen Struktur das Blech (1) gefaltet und zu einer Rolle (1") aufgewickelt wird, dass die Rolle (1") in senkrechter Richtung zu ihrer Längsachse zusammengepresst wird und dass zur Bildung der Platte (P) die zusammengepresste Rolle (1''') entlang ihrer Längsachse in Scheiben (12) geschnitten wird.

10. Verfahren nach Anspruch 9, **dadurch gekennzeichnet, dass** das Blech (1) zur Faltung in regelmässigen Abständen geknickt wird und dass die Wicklung derart erfolgt, dass die Rolle (1") einen sternförmigen Querschnitt aufweist.

11. Verfahren nach Anspruch 9, **dadurch gekennzeichnet, dass** die Rolle (1") in eine rechteckförmige, insbesondere quadratische Querschnittsform gepresst wird.

12. Verfahren nach Anspruch 9, **dadurch gekennzeichnet, dass** die Rolle (1") in Richtung senkrecht zur Längsachse bis zu einer Dichte von 70 bis 99% zusammengepresst wird.

13. Verfahren nach Anspruch 9, **dadurch gekennzeichnet, dass** die Scheiben (12) in Richtung senkrecht zu ihrer Scheibenebene verpresst werden.

14. Pufferelement zur Verminderung von mechanischen Spannungen zwischen zwei Materialien mit unterschiedlichen thermischen Ausdehnungskoeffizienten, **dadurch gekennzeichnet, dass** das Pufferelement plattenförmig ausgebildet ist und aus einem einstückigen, eine zusammengepresste mäanderartige Form aufweisendes Blech besteht.

15. Pufferelement nach Anspruch 14, **dadurch gekennzeichnet, dass** das Blech in Richtung senkrecht zu einer Fläche des Pufferelementes mäanderförmig zusammengefaltet ist.

16. Pufferelement nach Anspruch 14, **dadurch gekennzeichnet, dass** das Blech im wesentlichen in Form einer in einer Fläche des Pufferelementes verlaufenden Spirale gewickelt ist, wobei die Spirale Windungen aufweist, welche mäanderförmig verlaufen.
